# EUROPEAN PATENT APPLICATION

(11) **EP 4 577 004 A1**
(43) Date of publication of application: **25.06.2025**
(21) Application number: 24219904.0
(22) Date of filing: 13.12.2024
(51) Int. Cl.: H10H 20/83, H10H 20/831, H10H 20/84, H10H 20/85, H10H 20/841, H10H 29/14, H10H 29/24, H10H 29/34, H10H 29/85, H10H 29/853, H10H 29/80, H10H 20/813, H10H 20/853

(54) **SEMICONDUCTOR CHIP AND SEMICONDUCTOR DEVICE**

(30) Priority: 18.12.2023 US 202363611214 P; 11.11.2024 CN 202411595659
(71) Applicant: InnoLux Corporation, Chu-Nan, Miao-Li 350 (TW)
(72) Inventor: KUO, Shu-Ming, 350 Miao-Li County (TW)
(74) Representative: Straus, Alexander

(57) **Abstract**

A semiconductor chip (SC) includes a first semiconductor die (DI1), a second semiconductor die (DI2), a filling layer (FL), a conductive layer (TL) and a reflective layer (RL). The second semiconductor die (DI2) is disposed on the first semiconductor die (DI1) and electrically connected to the first semiconductor die (DI1). The filling layer (FL) surrounds a sidewall (SW1,SW3) of the first semiconductor die (DI1) and a sidewall (SW2,SW4) of the second semiconductor die (DI2). The conductive layer (TL) is disposed on the second semiconductor die (DI2) and the filling layer (FL) and electrically connected to the second semiconductor die (DI2). The reflective layer (RL) is disposed on a sidewall (SW5) of the filling layer (FL).

## Description

### Field of the Disclosure

The present disclosure relates to a semiconductor chip and a semiconductor device, and more particularly to a semiconductor chip and a semiconductor device including a plurality of semiconductor dies.

### Background of the Disclosure

In current light emitting diode display devices driven by active matrix, since the voltage consumed by the driving elements (such as thin film transistors) is greater than the voltage consumed by a single light emitting diode when the light emitting diode emits light, energy utilization efficiency may reduce, or energy consumption of the display device may increase. Therefore, to solve the above-mentioned problem is still an important issue in the present field.

### Summary of the Disclosure

This is in mind, the present disclosure aims at providing a semiconductor chip and a semiconductor device, wherein a pixel of the semiconductor chip or the semiconductor device includes a plurality of semiconductor dies which are connected to each other in series. Therefore, driving efficiency or energy utilization efficiency of the semiconductor chip or the semiconductor device may be improved.

This is achieved by a semiconductor chip or a semiconductor device according to the claims. The dependent claims pertain to corresponding further developments and improvements.

As will be seen more clearly from the detailed description following below, a semiconductor chip is provided by the present disclosure. The semiconductor chip includes a first semiconductor die, a second semiconductor die, a filling layer, a conductive layer and a reflective layer. The second semiconductor die is disposed on the first semiconductor die and electrically connected to the first semiconductor die. The filling layer surrounds a sidewall of the first semiconductor die and a sidewall of the second semiconductor die. The conductive layer is disposed on the second semiconductor die and the filling layer and electrically connected to the second semiconductor die. The reflective layer is disposed on a sidewall of the filling layer.

In addition, a semiconductor device is provided by the present disclosure. The semiconductor device includes a substrate, a first semiconductor die, a second semiconductor die, a first filling layer, a second filling layer, a first conductive layer, a first reflective layer and a second reflective layer. The first semiconductor die is disposed on the substrate. The second semiconductor die is disposed on the first semiconductor die and electrically connected to the first semiconductor die. The first filling layer surrounds a sidewall of the first semiconductor die. The second filling layer surrounds a sidewall of the second semiconductor die. The first conductive layer is disposed on the second semiconductor die and electrically connected to the second semiconductor die. The first reflective layer is disposed on a sidewall of the first filling layer. The second reflective layer is disposed on a sidewall of the second filling layer.

These and other objectives of the present disclosure will no doubt become obvious to those of ordinary skill in the art after reading the following detailed description of the embodiment that is illustrated in the various figures and drawings.

### Brief Description of the Drawings

In the following, the disclosure is further illustrated by way of example, taking reference to the accompanying drawings. Thereof:
FIG. 1 schematically illustrates a cross-sectional view of a semiconductor chip according to a first embodiment of the present disclosure;
FIG. 2 schematically illustrates the electrical connection ways of a first semiconductor die and a second semiconductor die in a semiconductor chip of the present disclosure;
FIG. 3 schematically illustrates a cross-sectional view of a semiconductor chip according to a variant embodiment of the first embodiment of the present disclosure;
FIG. 4 schematically illustrates a cross-sectional view of a semiconductor chip according to a second embodiment of the present disclosure;
FIG. 5 schematically illustrates a cross-sectional view of a semiconductor device according to a third embodiment of the present disclosure;
FIG. 6 schematically illustrates a cross-sectional view of a semiconductor device according to a fourth embodiment of the present disclosure;
FIG. 7 schematically illustrates a cross-sectional view of a semiconductor device according to a fifth embodiment of the present disclosure; and
FIG. 8 schematically illustrates the circuit diagrams of the semiconductor device in different operating modes according to the fifth embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the device, and certain elements in various drawings may not be drawn to scale. In addition, the number and dimension of each element shown in drawings are only illustrative and are not intended to limit the scope of the present disclosure.

Certain terms are used throughout the description and following claims to refer to particular elements. As one skilled in the art will understand, electronic equipment manufacturers may refer to an element by different names. This document does not intend to distinguish between elements that differ in name but not function.

In the following description and in the claims, the terms "include", "comprise" and "have" are used in an open-ended fashion, and thus should be interpreted to mean "include, but not limited to...".

It will be understood that when an element or layer is referred to as being "disposed on" or "connected to" another element or layer, it can be directly on or directly connected to the other element or layer, or intervening elements or layers may be presented (indirectly). In contrast, when an element is referred to as being "directly on" or "directly connected to" another element or layer, there are no intervening elements or layers presented. When an element or a layer is referred to as being "electrically connected" to another element or layer, it can be a direct electrical connection or an indirect electrical connection. The electrical connection or coupling described in the present disclosure may refer to a direct connection or an indirect connection. In the case of a direct connection, the ends of the elements on two circuits are directly connected or connected to each other by a conductor segment. In the case of an indirect connection, switches, diodes, capacitors, inductors, resistors, other suitable elements or combinations of the above elements may be included between the ends of the elements on two circuits, but not limited thereto.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

According to the present disclosure, the thickness, length and width may be measured through optical microscope, and the thickness or width may be measured through the cross-sectional view in the electron microscope, but not limited thereto.

In addition, any two values or directions used for comparison may have certain errors. In addition, the terms "equal to", "equal", "the same", "approximately" or "substantially" are generally interpreted as being within ± 20%, ± 10%, ± 5%, ± 3%, ± 2%, ± 1%, or ± 0.5% of the given value.

In addition, the terms "the given range is from a first value to a second value" or "the given range is located between a first value and a second value" represents that the given range includes the first value, the second value and other values there between.

If a first direction is said to be perpendicular to a second direction, the included angle between the first direction and the second direction may be located between 80 to 100 degrees. If a first direction is said to be parallel to a second direction, the included angle between the first direction and the second direction may be located between 0 to 10 degrees.

Unless it is additionally defined, all terms (including technical and scientific terms) used herein have the same meaning as commonly understood by those ordinary skilled in the art. It can be understood that these terms that are defined in commonly used dictionaries should be interpreted as having meanings consistent with the relevant art and the background or content of the present disclosure, and should not be interpreted in an idealized or overly formal manner, unless it is specifically defined in the embodiments of the present disclosure.

It should be noted that the technical features in different embodiments described in the following can be replaced, recombined, or mixed with one another to constitute another embodiment without departing from the spirit of the present disclosure.

The semiconductor chip and the semiconductor device of the present disclosure may be applied to any suitable electronic device, wherein the electronic device may include a display device, a sensing device, a back-light device, an antenna device, a tiled device or other suitable devices. The electronic device may be a foldable electronic device, a flexible electronic device or a stretchable electronic device. The display device may for example be applied to laptops, common displays, tiled displays, vehicle displays, touch displays, televisions, monitors, smart phones, tablets, light source modules, lighting devices or electronic devices applied to the products mentioned above, but not limited thereto. The sensing device may include a biosensor, a touch sensor, a fingerprint sensor, other suitable sensors or combinations of the above-mentioned sensors. The antenna device may include a liquid crystal antenna device or a non-liquid crystal antenna device, but not limited thereto. The tiled device may for example include a tiled display device or a tiled antenna device, but not limited thereto. The outline of the electronic device may be a rectangle, a circle, a polygon, a shape with curved edge or other suitable shapes. The electronic device may include electronic units, wherein the electronic units may include passive elements or active elements, such as capacitor, resistor, inductor, diode, transistor, sensors, and the like. The diode may include a light emitting diode or a photo diode. The light emitting diode may for example include an organic light emitting diode (OLED) or an inorganic light emitting diode. The inorganic light emitting diode may for example include a mini light emitting diode (mini LED), a micro light emitting diode (micro LED) or a quantum dot light emitting diode (QLED), but not limited thereto. It should be noted that the electronic device of the present disclosure may be combinations of the above-mentioned devices, but not limited thereto. The electronic device may include peripheral systems such as driving systems, controlling systems, light source systems to support display devices, antenna devices, wearable devices (such as augmented reality devices or virtual reality devices), vehicle devices (such as windshield of car) or tiled devices.

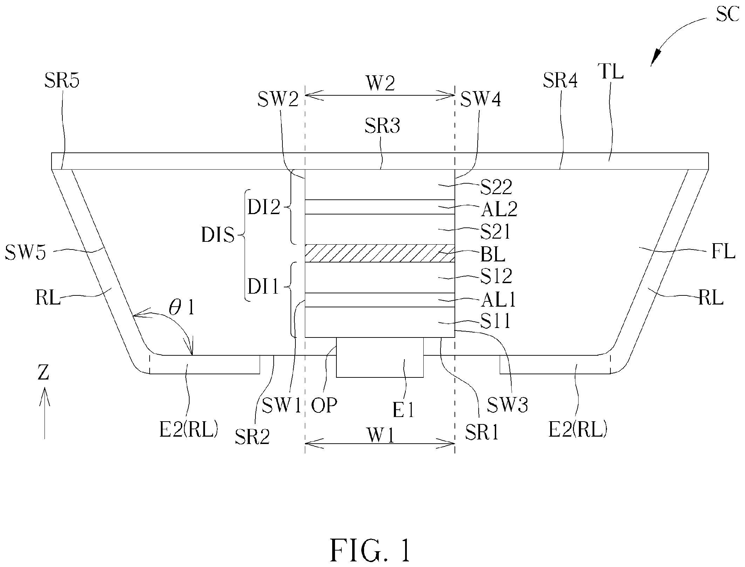

Referring to FIG. 1, FIG. 1 schematically illustrates a cross-sectional view of a semiconductor chip according to a first embodiment of the present disclosure. The semiconductor chip SC of the present disclosure may be applied to any suitable electronic device, such as display device, sensing device, other suitable devices or combinations of the above-mentioned devices. As shown in FIG. 1, the semiconductor chip SC of the present disclosure may include a first semiconductor die DI1, a second semiconductor die DI2, a filling layer FL, a conductive layer TL and a reflective layer RL, but not limited thereto. The structures and disposition positions of the elements in the semiconductor chip SC will be detailed in the following.

According to the present disclosure, the semiconductor chip SC may include a plurality of semiconductor dies, such as two semiconductor dies, but not limited thereto. In detail, as shown in FIG. 1, the semiconductor chip SC may include the first semiconductor die DI1 and the second semiconductor die DI2, wherein the second semiconductor die DI2 is disposed on the first semiconductor die DI1. Specifically, the first semiconductor die DI1 and the second semiconductor die DI2 may be stacked along a normal direction (that is, the direction Z, which will not be redundantly described) of the semiconductor chip SC. In other words, the semiconductor chip SC may include a die stacking structure DIS formed by stacking the first semiconductor die DI1 and the second semiconductor die DI2 along the normal direction of the semiconductor chip SC. In the present embodiment, in a cross-sectional view of the semiconductor chip SC (for example, FIG. 1), a side of the first semiconductor die DI1 has a sidewall SW1, and the side of the second semiconductor die DI2 has a sidewall SW2, wherein the sidewall SW1 may be aligned with the sidewall SW2, but not limited thereto. In addition, the first semiconductor die DI1 may further include a sidewall SW3 opposite to the sidewall SW1, and the second semiconductor die DI2 may further include a sidewall SW4 opposite to the sidewall SW2, wherein the sidewall SW3 may be aligned with the sidewall SW4. In such condition, in a cross-sectional view of the semiconductor chip SC, the first semiconductor die DI1 may have a width W1, and the second semiconductor die DI2 may have a width W2, wherein the width W1 may substantially be the same as the width W2, but not limited thereto. The first semiconductor die DI1 and the second semiconductor die DI2 may include any suitable semiconductor element, based on the type or usage of the semiconductor chip SC. The semiconductor element described herein may be any suitable element including a semiconductor layer or formed through a semiconductor process. For example, in the present embodiment, the semiconductor chip SC may be applied to a display device, and the first semiconductor die DI1 and the second semiconductor die DI2 may include light emitting diode, but not limited thereto. The light emitting diode may include an organic light emitting diode (OLED) or an inorganic light emitting diode. The inorganic light emitting diode may for example include a mini light emitting diode (mini LED), a micro light emitting diode (micro LED) or a quantum dot light emitting diode (QLED). For example, the first semiconductor die DI1 and the second semiconductor die DI2 may include micro LED in the present embodiment, but not limited thereto. In such condition, as shown in FIG. 1, the first semiconductor die DI1 may include a first semiconductor layer S11, a second semiconductor layer S12 and an active layer AL1 disposed between the first semiconductor layer S11 and the second semiconductor layer S12; and the second semiconductor die DI2 may include a first semiconductor layer S21, a second semiconductor layer S22 and an active layer AL2 disposed between the first semiconductor layer S21 and the second semiconductor layer S22. The first semiconductor layer S11 and the first semiconductor layer S21 above may be one of the n-type semiconductor layer and the p-type semiconductor layer, and the second semiconductor layer S12 and the second semiconductor layer S22 above may be another one of the n-type semiconductor layer and the p-type semiconductor layer. The first semiconductor layer S11, the active layer AL1 and the second semiconductor layer S12 may be stacked sequentially along the normal direction of the semiconductor chip SC to form the first semiconductor die DI1, and the first semiconductor layer S21, the active layer AL2 and the second semiconductor layer S22 may be stacked sequentially along the normal direction of the semiconductor chip SC to form the second semiconductor die DI2, but not limited thereto. In some embodiments, the first semiconductor die DI1 (or the second semiconductor die DI2) may be formed by stacking the second semiconductor layer S12 (or the second semiconductor layer S22), the active layer AL1 (or the active layer AL2) and the first semiconductor layer S 11 (or the first semiconductor layer S21) sequentially along the normal direction of the semiconductor chip SC. In the present embodiment, the first semiconductor die DI1 and the second semiconductor die DI2 may be the light emitting diodes emitting lights of the same color, but not limited thereto. For example, the first semiconductor die DI1 and the second semiconductor die DI2 may both emit one of the red light, the green light and the blue light, but not limited thereto. In some embodiments, the first semiconductor die DI1 and the second semiconductor die DI2 may emit lights of different colors. In some embodiments, at least one of the first semiconductor die DI1 and the second semiconductor die DI2 include light emitting diode. That is, one of the first semiconductor die DI1 and the second semiconductor die DI2 may include light emitting diode, and another one of the first semiconductor die DI1 and the second semiconductor die DI2 may include other suitable semiconductor elements. It should be noted that the application of the semiconductor chip SC and the structures of the first semiconductor die DI1 and the second semiconductor die DI2 are not limited to the contents mentioned above. In some embodiments, the semiconductor chip SC may be applied to a sensing device, and at least one of the first semiconductor die DI1 and the second semiconductor die DI2 may include photodiode. In some embodiments, the semiconductor chip SC may be applied to an electronic device of other types, and the first semiconductor die DI1 and the second semiconductor die DI2 may include suitable types of semiconductor elements. In some embodiments, the active layer AL1 (or the active layer AL2) may be a light-emitting layer, a photosensitive layer, or an intrinsic layer. In some embodiment, a width of the first semiconductor die DI1 (or the second semiconductor die DI2) may range from 1 to 30 micrometers. In some embodiment, a width of the semiconductor chip SC may range from 1 to 100 micrometers.

According to the present disclosure, the second semiconductor die DI2 may be electrically connected to the first semiconductor die DI1. Specifically, the first semiconductor die DI1 and the second semiconductor die DI2 may be connected to each other in series. In such condition, as shown in FIG. 1, the second semiconductor layer S12 of the first semiconductor die DI1 is adjacent to the first semiconductor layer S21 of the second semiconductor die DI2, but not limited thereto. In some embodiments, the first semiconductor layer S11 of the first semiconductor die DI1 is adjacent to the second semiconductor layer S22 of the second semiconductor die DI2. In detail, the semiconductor chip SC may further include a bonding layer BL disposed between the first semiconductor die DI1 and the second semiconductor die DI2. The bonding layer BL may include any suitable conductive material and be used for electrically connecting the first semiconductor die DI1 and the second semiconductor die DI2. The electrical connection ways of the first semiconductor die DI1 and the second semiconductor die DI2 of the present disclosure will be detailed in the following.

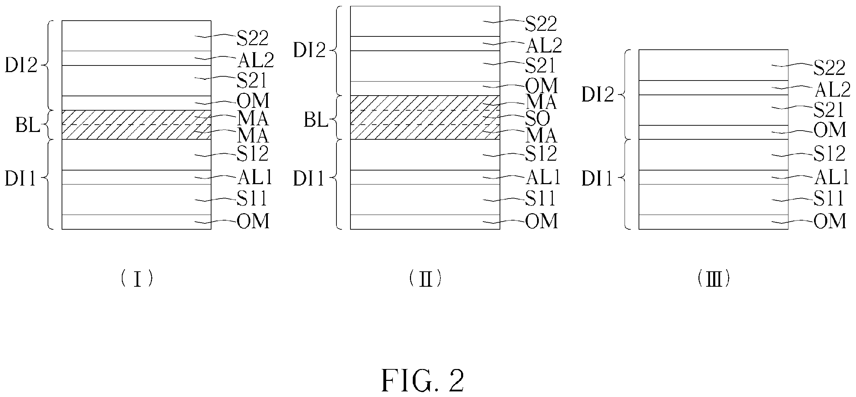

Referring to FIG. 2, FIG. 2 schematically illustrates the electrical connection ways of a first semiconductor die and a second semiconductor die in a semiconductor chip of the present disclosure. Specifically, FIG. 2 shows embodiments of electrical connection way of the first semiconductor die DI1 and the second semiconductor die DI2. It should be noted that in some embodiments, as shown in FIG. 2, the first semiconductor die DI1 and the second semiconductor die DI2 further include an ohmic contact layer OM respectively. The ohmic contact layer OM of the second semiconductor die DI2 is disposed at a side of the first semiconductor layer S21 away from the active layer AL2 and is adjacent to the first semiconductor die DI1, and the ohmic contact layer OM of the first semiconductor die DI1 is disposed at a side of the first semiconductor layer S11 away from the active layer AL1 and is away from the second semiconductor die DI2. In other words, the semiconductor die may be formed by stacking the ohmic contact layer, the first semiconductor layer, the active layer and the second semiconductor layer sequentially along the normal direction of the semiconductor chip SC, but not limited thereto. The ohmic contact layer OM may for example include indium tin oxide (ITO), but not limited thereto.

In some embodiments, the first semiconductor die DI1 and the second semiconductor die DI2 may be electrically connected to each other through metal-metal bonding. Specifically, as shown in the structure (I) of FIG. 2, a metal material layer MA may be formed at a side of the first semiconductor die DI1 adjacent to the second semiconductor die DI2, and another metal material layer MA may be formed at a side of the second semiconductor die DI2 adjacent to the first semiconductor die DI1. That is, the metal material layer MA of the first semiconductor die DI1 may be formed on the second semiconductor layer S12, and the metal material layer MA of the second semiconductor die DI2 may be formed below the ohmic contact layer OM, but not limited thereto. After that, the first semiconductor die DI1 and the second semiconductor die DI2 may be bonded in the way that the metal material layer MA of the first semiconductor die DI1 contacts the metal material layer MA of the second semiconductor die DI2. The metal material layer MA may for example include copper (Cu), but not limited thereto. In such condition, the bonding layer BL may be regarded as the conductive structure formed by the metal material layers MA. The bonding layer BL may include a single-layer structure or a multi-layer structure, based on the materials or the structures of the metal material layer MA of the first semiconductor die DI1 and the metal material layer MA of the second semiconductor die DI2. For example, in some embodiments, the bonding layer BL may include a single-layer structure formed of a metal material. In some embodiments, the bonding layer BL may include a multi-layer structure formed by stacking a plurality of metal materials.

In some embodiments, the first semiconductor die DI1 and the second semiconductor die DI2 may be electrically connected to each other through solder bonding. Specifically, as shown in the structure (II) of FIG. 2, a metal material layer MA may be formed at a side of the first semiconductor die DI1 adjacent to the second semiconductor die DI2, and another metal material layer MA may be formed at a side of the second semiconductor die DI2 adjacent to the first semiconductor die DI1. The features of the metal material layer MA may refer to the contents mentioned above, and will not be redundantly described. After that, the metal material layer MA of the first semiconductor die DI1 may be bonded to the metal material layer MA of the second semiconductor die DI2 through a solder SO, thereby electrically connecting the first semiconductor die DI1 and the second semiconductor die DI2. That is, the solder SO is sandwiched between the metal material layer MA of the first semiconductor die DI1 and the metal material layer MA of the second semiconductor die DI2. In such condition, the bonding layer BL may be regarded as a multi-layer conductive structure formed by stacking the metal material layers MA and the solder SO.

In some embodiments, the first semiconductor die DI1 and the second semiconductor die DI2 may be electrically connected to each other through fusion bonding. Specifically, as shown in the structure (III) of FIG. 2, the ohmic contact layer OM of the second semiconductor die DI2 may directly contact the second semiconductor layer S12 of the first semiconductor die DI1, thereby electrically connecting the first semiconductor die DI1 and the second semiconductor die DI2, but not limited thereto. In some embodiments, the semiconductor die may not include the ohmic contact layer OM, and the first semiconductor layer S21 of the second semiconductor die DI2 may directly contact the second semiconductor layer S12 of the first semiconductor die DI1. In such condition, the first semiconductor die DI1 may not be electrically connected to the second semiconductor die DI2 through the bonding layer BL, that is, the semiconductor chip SC may not include the bonding layer BL.

It should be noted that the electrical connection ways of the first semiconductor die DI1 and the second semiconductor die DI2 shown in FIG. 2 are exemplary, and it is not limited in the present disclosure. The first semiconductor die DI1 and the second semiconductor die DI2 may be electrically connected to each other through other suitable ways.

Back to FIG. 1, the semiconductor chip SC of the present disclosure further includes a filling layer FL, wherein the filling layer FL may surround the sidewall (for example, the sidewall SW1 and the sidewall SW3) of the first semiconductor die DI1 and the sidewall (for example, the sidewall SW2 and the sidewall SW4) of the second semiconductor die DI2. Specifically, in a top view (not shown) of the semiconductor chip SC, the filling layer FL may be disposed along the outer edge of the first semiconductor die DI1 and the outer edge of the second semiconductor die DI2 and surround the first semiconductor die DI1 and the second semiconductor die DI2. In such condition, the filling layer FL may contact the sidewall of the first semiconductor die DI1 and the sidewall of the second semiconductor die DI2. In detail, the first semiconductor die DI1 and the second semiconductor die DI2 may be bonded through the above-mentioned way to form the die stacking structure DIS at first, and then the filling layer FL may be disposed to surround the die stacking structure DIS. In the present embodiment, the filling layer FL may also partially contact the surface of the first semiconductor die DI1 away from the second semiconductor die DI2, but not limited thereto. For example, the first semiconductor die DI1 may include a surface SR1 away from the second semiconductor die DI2, and the filling layer FL may partially cover the surface SR1. Specifically, the filling layer FL may include a surface SR2 adjacent to the surface SR1, wherein the surface SR2 may be located below the surface SR1, and a portion of the filling layer FL may extend on the surface SR1 and partially cover the surface SR1. In some embodiments, the surface SR1 may be aligned with the surface SR2. The portion of the surface SR1 not covered by the filling layer FL may be used to dispose a first electrode E1 electrically connected to the first semiconductor die DI1. In addition, in the present embodiment, the filling layer FL may not cover the surface of the second semiconductor die DI2 away from the first semiconductor die DI1. For example, the second semiconductor die DI2 may include a surface SR3 away from the first semiconductor die DI1, and the filling layer FL may not cover the surface SR3. Specifically, the filling layer FL may include a surface SR4 adjacent to the surface SR3, wherein the surface SR4 may be aligned with the surface SR3, but not limited thereto. Through the above-mentioned disposition way, it is convenient to dispose the conductive layer TL on the filling layer FL and the second semiconductor die DI2 in subsequent process. The filling layer FL may include any suitable high transmittance material, such as acrylic, siloxane, silica, other suitable materials or combinations of the above-mentioned materials. For example, the transmittance of the filling layer FL of the present embodiment to visible light may be greater than 90%. According to the present disclosure, in a top view of the semiconductor chip SC, the shape of the outer edge of the semiconductor chip SC may be determined by the shape of the outer edge of the filling layer FL. That is, the shape of the outer edge of the filling layer FL may be determined according to the demand of shape of the semiconductor chip SC. For example, in an embodiment, the outer edge of the filling layer FL (for example, the outer edge of the surface SR4 or the outer edge of the surface SR2) may be circular, such that the semiconductor chip SC has a circular outline in a top view. In an embodiment, the outer edge of the filling layer FL may be rectangular, such that the semiconductor chip SC has a rectangular outline in a top view. In addition, in a cross-sectional view of the semiconductor chip SC, the filling layer FL may have a sidewall SW5, wherein the sidewall SW5 is connected between the surface SR4 and the surface SR2 of the filling layer FL. In the present embodiment, the sidewall SW5 may not be perpendicular to the surface SR2 and the surface SR4, and the size (for example, area) of the surface SR2 may be different from the size of the surface SR4. For example, the size of the surface SR2 is less than the size of the surface SR4, but not limited thereto. In such condition, an included angle θ1 is included between the sidewall SW5 and the surface SR2. According to the present embodiment, the included angle θ1 may range from 100 degrees to 170 degrees (that is, 100°≤θ1≤170°), but not limited thereto. In some embodiments, the included angle θ1 may range from 110 degrees to 150 degrees (that is, 110°≤θ1≤150°). The value of the included angle θ1 may be determined according to the shape design of the filling layer FL. Through the range design of the above-mentioned included angle θ1, the light emitting effect of the semiconductor chip SC may be improved after the reflective layer RL is subsequently disposed. In some embodiments, the intersection of the sidewall SW5 and the surface SR2 is arc-shaped in a cross-sectional view. Specifically, an arc-shaped surface may be included between the sidewall SW5 and the surface SR2.

According to the present disclosure, the semiconductor chip SC may further include a first electrode E1, wherein the first electrode E1 is disposed below the first semiconductor die DI1 and electrically connected to the first semiconductor die DI1. Specifically, as shown in FIG. 1, the first electrode E1 may be disposed corresponding to the portion of the surface SR1 of the first semiconductor die DI1 not covered by the filling layer FL, or in other words, the portion of the filling layer FL extending on the surface SR1 may include an opening OP, and the first electrode E1 may be filled in the opening OP. The first electrode E1 may contact the first semiconductor die DI1, or in other words, the first electrode E1 may contact the first semiconductor layer S11 of the first semiconductor die DI1, but not limited thereto. In some embodiments, the first electrode E1 may contact the ohmic contact layer OM mentioned above. The first electrode E1 may include any suitable conductive material, such as metal materials or transparent conductive materials.

According to the present disclosure, the semiconductor chip SC further includes a reflective layer RL disposed on the sidewall (for example, the sidewall SW5) of the filling layer FL. Specifically, the reflective layer RL may surround the filling layer FL and cover the side surface of the filling layer FL. In addition, in the present embodiment, the reflective layer RL may further extend on the surface SR2 of the filling layer FL but not contact the first electrode E1. Specifically, in a bottom view of the semiconductor chip SC (or viewed from the bottom of the semiconductor chip SC), the portion of the reflective layer RL located on the surface SR2 may have a ring structure, wherein the ring structure may expose the first electrode E1 and at least a portion of the filling layer FL. The reflective layer RL may have high reflectivity and high conductivity. For example, in some embodiments, the reflective layer RL may include a single-layer structure, and in this case, a conductive material with high reflectivity may be selected as the material of the reflective layer RL, such as silver (Ag) or aluminum (Al), but not limited thereto. That is, the reflective layer RL may include metal material. In other embodiments, the reflective layer RL may include a multi-layer structure, wherein each of the sub layers in the multi-layer structure may include the material with high reflectivity or high conductivity. In some embodiments, the first electrode E1 and the reflective layer RL may include the same material, or the first electrode E1 and the reflective layer RL may be formed through the same process. Through the disposition of the reflective layer RL, the light emitted by the first semiconductor die DI1 and the second semiconductor die DI2 may be reflected by the reflective layer RL, thereby increasing the amount of output light. It should be noted that the included angle θ1 mentioned above may also be regarded as the included angle between a portion of the reflective layer RL extending on the surface SR2 and another portion of the reflective layer RL extending on the sidewall SW5. By making the included angle θ1 located within the above-mentioned range, the light emitting effect of the semiconductor chip SC may be improved.

According to the present disclosure, the semiconductor chip SC further includes a conductive layer TL disposed on the second semiconductor die DI2 and the filling layer FL. Specifically, the conductive layer TL may be disposed on the surface SR3 of the second semiconductor die DI2 and the surface SR4 of the filling layer FL and contact the second semiconductor die DI2 and the filling layer FL. In detail, the conductive layer TL may directly contact the second semiconductor layer S22 of the second semiconductor die DI2. Therefore, the conductive layer TL may be electrically connected to the second semiconductor die DI2. The conductive layer TL may include any suitable transparent conductive material, such as indium tin oxide (ITO), indium zinc oxide (IZO) or indium gallium oxide (IGO), but not limited thereto. In some embodiments, the conductive layer TL may include metal with high transmittance, such as magnesium (Mg) or silver (Ag), but not limited thereto. Specifically, the conductive layer TL may be formed by forming a very thin metal layer (such as a magnesium layer, a silver layer or a magnesium-silver alloy layer). In some embodiments, a metal mesh layer having light-transmitting openings may be formed through screen printing or other patterning processes, thereby forming the conductive layer TL. In addition, according to the present embodiment, the conductive layer TL may further be disposed on the reflective layer RL and contact the reflective layer RL. For example, the conductive layer TL may further extend on the surface SR5 of the reflective layer RL. In such condition, the conductive layer TL may be electrically connected to the second semiconductor die DI2 and the reflective layer RL, or the conductive layer TL is electrically connected between the second semiconductor die DI2 and the reflective layer RL. In the present embodiment, the conductive layer TL may be disposed entirely on the second semiconductor die DI2, the filling layer FL and the reflective layer RL, but not limited thereto. In other embodiments, as long as the conductive layer TL is electrically connected to the second semiconductor die DI2 and the reflective layer RL, the conductive layer TL may have any suitable pattern. In some embodiments, the conductive layer TL is a transparent conductive layer.

According to the present disclosure, the semiconductor chip SC may further include a second electrode E2, wherein the second electrode E2 is disposed below the filling layer FL. Specifically, in the present embodiment, the portion of the reflective layer RL extending on the surface SR2 of the filling layer FL (or the portion of the reflective layer RL not disposed on the sidewall of the filling layer FL) may be defined as the second electrode E2. In such condition, the second electrode E2 is located below the filling layer FL and electrically connected to the reflective layer RL, and the second electrode E2 may be electrically connected to the conductive layer TL through the reflective layer RL. That is, the second semiconductor die DI2 may be electrically connected to the second electrode E2 through the conductive layer TL and the reflective layer RL. In addition, the material of the second electrode E2 may be the same as the material of the reflective layer RL. In the present embodiment, one of the first electrode E1 and the second electrode E2 may be the p electrode, and another one of the first electrode E1 and the second electrode E2 may be the n electrode, based on the types of the first semiconductor layer and the second semiconductor layer mentioned above. According to the present embodiment, through the above-mentioned structural design, the first electrode E1 electrically connected to the first semiconductor die DI1 and the second electrode E2 electrically connected to the second semiconductor die DI2 may be located at the same side of the semiconductor chip SC. Therefore, when the semiconductor chip SC is bonded to another electronic unit through the first electrode E1 and the second electrode E2 in subsequent process, the semiconductor chip SC may for example be bonded to the another electronic units in a flip chip way. In such condition, the semiconductor chip SC of the present embodiment may have a vertical embedded flip chip structure. Specifically, the first semiconductor die DI1 and the second semiconductor die DI2 of the semiconductor chip SC may include vertical type light emitting diode elements, and after the first semiconductor die DI1 and the second semiconductor die DI2 are encapsulated through the filling layer FL, and the elements such as the reflective layer RL, the first electrode E1, the conductive layer TL, and the like are disposed, the semiconductor chip SC may be bonded to another electronic units through the first electrode E1 and the second electrode E2 located at the same side in a flip chip way. It should be noted that the semiconductor chip SC of the present disclosure may further include other suitable structures, which is not limited to what is shown in FIG. 1.

According to the present embodiment, by making the semiconductor chip SC include a plurality of semiconductor dies which are connected to each other in series, in the process of driving the semiconductor chip SC to emit light, the voltage consumed by the semiconductor chip SC may increase, or the proportion of the voltage consumed by the semiconductor chip SC to the overall voltage consumed during the driving process of the semiconductor chip SC may increase. Therefore, the energy utilization efficiency of the electronic device to which the semiconductor chip SC is applied may be improved, or the driving efficiency of the semiconductor chip SC may be improved. It should be noted that the semiconductor chip SC of the present disclosure may further include other suitable elements or layers, which is not limited to the structure shown in FIG. 1. Other embodiments of the present disclosure will be described in the following. In order to simplify the description, the same elements or layers in the following embodiments would be labeled with the same symbol, and the features thereof will not be redundantly described. The differences between the embodiments will be detailed in the following.

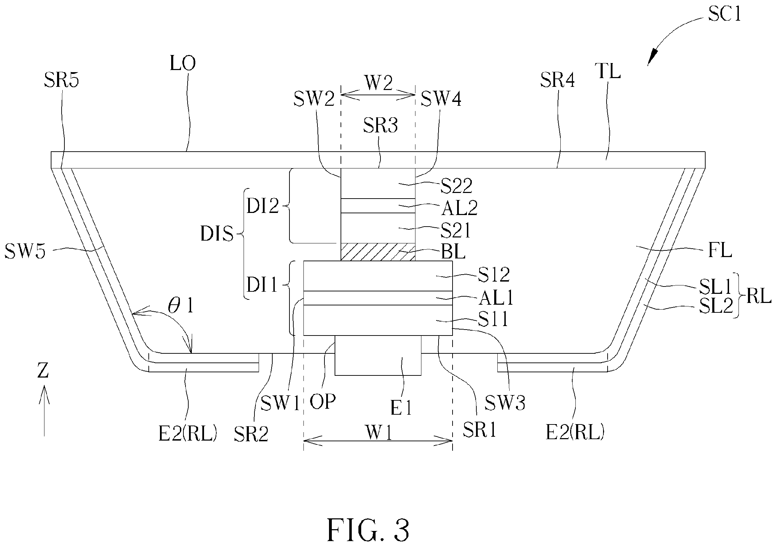

Referring to FIG. 3, FIG. 3 schematically illustrates a cross-sectional view of a semiconductor chip according to a variant embodiment of the first embodiment of the present disclosure. In the present variant embodiment, the sizes of the two semiconductor dies of the semiconductor chip SC1 may be different. Specifically, in the semiconductor chip SC1, the size of the semiconductor die closer to the light emitting surface of the semiconductor chip SC1 may be less than the size of the semiconductor die farther from the light emitting surface of the semiconductor chip SC1, but not limited thereto. In detail, as shown in FIG. 3, the semiconductor chip SC1 may have a light emitting surface LO, wherein the light emitting surface LO is located at the side where the conductive layer TL is located. For example, the surface of the conductive layer TL away from the filling layer FL may be defined as the light emitting surface LO of the semiconductor chip SC1, but not limited thereto. According to the present variant embodiment, in the die stacking structure DIS, the second semiconductor die DI2 may be closer to the light emitting surface LO than the first semiconductor die DI1, and the size of the second semiconductor die DI2 may be less than the size of the first semiconductor die DI1. "The size of the first semiconductor die DI1 (or the second semiconductor die DI2)" described herein may be the width of the first semiconductor die DI1 (or the second semiconductor die DI2) in a cross-sectional view of the semiconductor chip SC1, but not limited thereto. For example, as shown in FIG. 3, in a cross-sectional view of the semiconductor chip SC1, the first semiconductor die DI1 may have a width W1, the second semiconductor die DI2 may have a width W2, wherein the width W2 may be less than the width W1. The width W1 of the first semiconductor die DI1 may be defined as the maximum width of the first semiconductor die DI1, and the width W2 of the second semiconductor die DI2 may be defined as the maximum width of the second semiconductor die DI2. In such condition, in a cross-sectional view of the semiconductor chip SC1, the sidewall SW1 of the first semiconductor die DI1 may not be aligned with the sidewall SW2 of the second semiconductor die DI2, or the sidewall SW3 of the first semiconductor die DI1 may not be aligned with the sidewall SW4 of the second semiconductor die DI2. In some embodiments, "the size of the first semiconductor die DI1 (or the second semiconductor die DI2)" mentioned above may be the area of the first semiconductor die DI1 (or the second semiconductor die DI2) in a top view of the semiconductor chip SC1, but not limited thereto. In other words, in a top view of the semiconductor chip SC1, the area of the second semiconductor die DI2 may be less than the area of the first semiconductor die DI1. That is, the second semiconductor die DI2 does not cover at least a portion of the first semiconductor die DI1. Through the above-mentioned size design, the influence of the second semiconductor die DI2 on the light emitting effect of the first semiconductor die DI1 may be reduced, thereby improving the light emitting effect of the semiconductor chip SC1, or improving the display effect of the electronic device (such as a display device) to which the semiconductor chip SC1 is applied. It should be noted that the size relationship between the first semiconductor die DI1 and the second semiconductor die DI2 in the present variant embodiment may be applied to the embodiments and variant embodiments of the present disclosure.

In addition, the reflective layer RL of the present variant embodiment may include a multi-layer structure. For example, as shown in FIG. 3, the reflective layer RL may include a first sub layer SL1 and a second sub layer SL2, but not limited thereto. The first sub layer SL1 may be disposed on the sidewall (for example, the sidewall SW5) of the filling layer FL, and the second sub layer SL2 may be disposed on the first sub layer SL1. That is, the first sub layer SL1 may be located between the second sub layer SL2 and the filling layer FL. The reflectivity of the first sub layer SL1 to visible light may be greater than the reflectivity of the second sub layer SL2 to visible light, and the conductivity of the second sub layer SL2 may be greater than the conductivity of the first sub layer SL1. Therefore, the first sub layer SL1 may be used to reflect the light emitted by the first semiconductor die DI1 and the second semiconductor die DI2, and the second sub layer SL2 may be used to electrically connect the reflective layer RL (or the second electrode E2) to the conductive layer TL. The first sub layer SL1 may include any suitable element or layer with high reflectivity, such as a distributed bragg reflector (DBR), but not limited thereto. The second sub layer SL2 may include a material with high conductivity, such as gold (Au), silver (Ag) or copper (Cu), but not limited thereto. The first sub layer SL1 and the second sub layer SL2 may respectively include a single-layer structure or a multi-layer structure, it is not limited in the present disclosure. It should be noted that the structure of the reflective layer RL in the present variant embodiment may be applied to the embodiments and variant embodiments of the present disclosure.

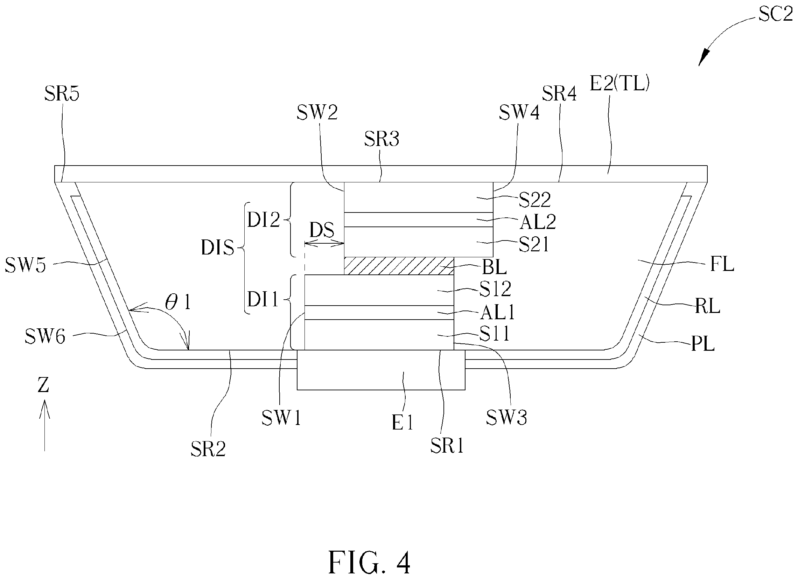

Referring to FIG. 4, FIG. 4 schematically illustrates a cross-sectional view of a semiconductor chip according to a second embodiment of the present disclosure. One of the main differences between the semiconductor chip SC2 of the present embodiment and the semiconductor chip SC shown in FIG. 1 is the disposition position of the reflective layer RL. Specifically, as shown in FIG. 4, the reflective layer RL of the semiconductor chip SC2 may be disposed on the sidewall (for example, the sidewall SW5) of the filling layer FL, extend on the surface SR2 of the filling layer FL, and contact the first electrode E1. In such condition, the reflective layer RL may be electrically connected to the first electrode E1. In addition, in the present embodiment, the reflective layer RL may not contact the conductive layer TL, or the reflective layer RL may not be electrically connected to the conductive layer TL. Specifically, the reflective layer RL does not contact the conductive layer TL and the first electrode E1 at the same time. It should be noted that in other embodiments, the reflective layer RL may contact the conductive layer TL but not contact the first electrode E1. Through the above-mentioned structural design, when the semiconductor chip SC2 is bonded to another electronic unit, the contact area between the first electrode E1 and the another electronic unit may increase, thereby improving the bonding process of the semiconductor chip SC2. In some embodiments, the reflective layer RL may be disposed only on the sidewall SW5 of the filling layer FL, that is, the reflective layer RL does not contact the first electrode E1 and the conductive layer TL. In some embodiments, regardless of whether the reflective layer RL contacts the first electrode E1 and/or the conductive layer TL, the reflective layer RL may not be electrically connected to the first electrode E1 and/or the conductive layer TL. For example, the reflective layer RL may only include a material with high reflectivity but not include conductive material.

In the present embodiment, the conductive layer TL of the semiconductor chip SC2 may serve as the electrode electrically connected to the second semiconductor die DI2, that is, the second electrode E2 mentioned above. In other words, the first electrode E1 and the second electrode E2 of the semiconductor chip SC2 may respectively be located at two opposite sides of the semiconductor chip SC2. In such condition, the semiconductor chip SC2 may have a vertical embedded chip structure. In detail, the first semiconductor die DI1 and the second semiconductor die DI2 may include vertical type light emitting diode elements that are embedded in the filling layer FL, thereby forming the semiconductor chip SC2.

In addition, in the present embodiment, the semiconductor chip SC2 may further include an insulating layer PL disposed on a sidewall SW6 of the reflective layer RL. As shown in FIG. 4, the insulating layer PL may be substantially conformal to the reflective layer RL and may cover the reflective layer RL. That is, the reflective layer RL may not be exposed by the insulating layer PL. The insulating layer PL may include any suitable insulating material and may be used to provide protection (for example, blocking water and oxygen) for the elements and/or the layers (such as the first semiconductor die DI1, the second semiconductor die DI2 and the reflective layer RL) of the semiconductor chip SC2. The insulating layer PL described in the present embodiment may be applied to the semiconductor chips in the embodiments and variant embodiments of the present disclosure.

In addition, in the present embodiment, the first semiconductor die DI1 may not be aligned with the second semiconductor die DI2 in the semiconductor chip SC2, but not limited thereto. Specifically, during the bonding process of the first semiconductor die DI1 and the second semiconductor die DI2, the offset between the first semiconductor die DI1 and the second semiconductor die DI2 may be caused by process tolerances, but not limited thereto. In detail, in a cross-sectional view of the semiconductor chip SC2, the sidewall SW1 of the first semiconductor die DI1 may not be aligned with the sidewall SW2 of the second semiconductor die DI2, or the sidewall SW3 of the first semiconductor die DI1 may not be aligned with the sidewall SW4 of the second semiconductor die DI2. In such condition, a distance DS may be included between the sidewall SW1 of the first semiconductor die DI1 and the sidewall SW2 of the second semiconductor die DI2, wherein the distance DS may range from 0 to 3 micrometers(µm)(that is, 0≤DS≤3µm), but not limited thereto. The distance DS described herein may be regarded as the offset distance of the second semiconductor die DI2 from the first semiconductor die DI1.

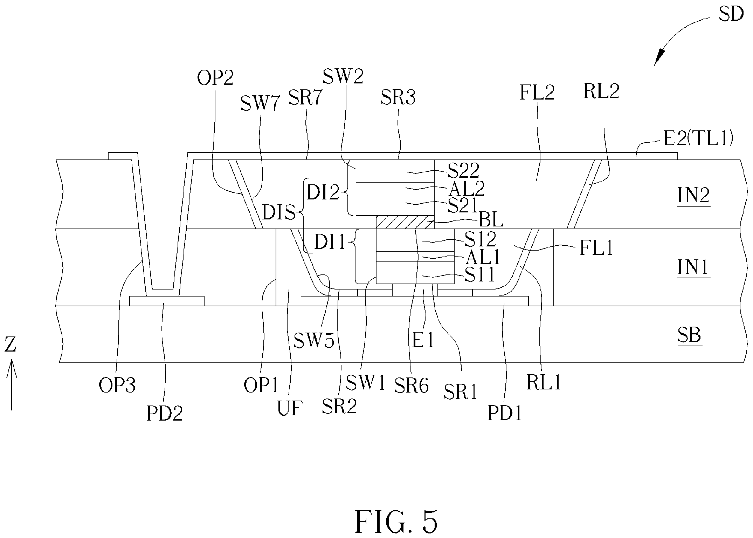

Referring to FIG. 5, FIG. 5 schematically illustrates a cross-sectional view of a semiconductor device according to a third embodiment of the present disclosure. The semiconductor device SD of the present disclosure may include any suitable electronic device, such as a display device, a sensing device, other suitable devices or combinations of the above-mentioned devices. As shown in FIG. 5, the semiconductor device SD may include a substrate SB, a first semiconductor die DI1, a second semiconductor die DI2, a first filling layer FL1, a second filling layer FL2, a first reflective layer RL1, a second reflective layer RL2 and a first conductive layer TL1, but not limited thereto. The structures and disposition positions of the elements and the layers in the semiconductor device SD will be detailed in the following.

According to the present embodiment, the substrate SB may include a driving substrate, such as an array substrate, but not limited thereto. For example, although it is not shown in FIG. 5, the substrate SB may include a base and a circuit layer disposed on the base. The base may support the elements and the layers disposed thereon. The base may include a rigid material or a flexible material. The rigid material for example includes glass, quartz, sapphire, ceramic, other suitable materials or combinations of the above-mentioned materials. The flexible material for example includes polyimide (PI), polycarbonate (PC), polyethylene terephthalate (PET), other suitable materials or combinations of the above-mentioned materials. The circuit layer may include various kinds of wires, circuits, electronic units that can be applied to the semiconductor device SD. The electronic unit may include any suitable active elements and/or passive elements. For example, the circuit layer CL may include a structure formed by stacking conductive layer(s) and insulating layer(s), wherein the conductive layer(s) may be used for forming the wires, the circuits or the electronic units mentioned above, but not limited thereto. The circuit layer may include a driving unit, wherein the driving unit may be electrically connected to the first semiconductor die DI1 and the second semiconductor die DI2, thereby controlling the light emission of the first semiconductor die DI1 and the second semiconductor die DI2. The driving unit may for example include a thin film transistor (TFT) element, but not limited thereto. It should be noted that the circuit layer may further include other suitable electronic units, which is not limited to the contents mentioned above.

The first semiconductor die DI1, the first filling layer FL1 and the first reflective layer RL1 may be disposed on the substrate SB. Specifically, the semiconductor device SD further includes an insulating layer IN1 disposed on the substrate SB, wherein the insulating layer IN1 includes an opening OP1, and the first semiconductor die DI1, the first filling layer FL1 and the first reflective layer RL1 may be disposed in the opening OP1. The first filling layer FL1 may surround the sidewall (for example, the sidewall SW1) of the first semiconductor die DI1. Specifically, in a top view of the semiconductor device SD (not shown), the first filling layer FL1 may be disposed along the outer edge of the first semiconductor die DI1 and surround the first semiconductor die DI1. The first reflective layer RL1 may be disposed on the sidewall SW5 of the first filling layer FL1. Specifically, the first reflective layer RL1 may surround the first filling layer FL1 and cover the side surface of the first filling layer FL1. In the present embodiment, the first reflective layer RL1 may further extend on the surface SR2 of the first filling layer FL1, but not limited thereto. In some embodiments, the first reflective layer RL1 may only be disposed on the sidewall SW5 of the first filling layer FL1 but not extend on the surface SR2. The semiconductor device SD of the present embodiment may further include a first electrode E1, wherein the first electrode E1 may be disposed in the opening OP1. Specifically, the first electrode E1 may be disposed below the first semiconductor die DI1 and electrically connected to the first semiconductor die DI1. For example, the first electrode E1 may contact the surface SR1 of the first semiconductor die DI1 facing the substrate SB, but not limited thereto. The first electrode E1 may be used to electrically connect the first semiconductor die DI1 to the substrate SB (or the circuit layer of the substrate SB). For example, the opening OP1 may expose the bonding pad PD1 in the circuit layer of the substrate SB, and the first electrode E1 may be disposed on the bonding pad PD1 and be electrically connected to the bonding pad PD1, thereby electrically connecting the first semiconductor die DI1 to the circuit layer (for example, electrically connecting the first semiconductor die DI1 to the driving unit in the circuit layer), but not limited thereto. The material selection or structural features of the first electrode E1 and the first semiconductor die DI1 may refer to the contents above, and will not be redundantly described. The material of the first filling layer FL1 may refer to the material of the filling layer FL mentioned above. The material of the first reflective layer RL1 may refer to the material of the reflective layer RL mentioned above. It should be noted that the first reflective layer RL1 may have high reflectivity and high conductivity in some embodiments. In such condition, although it is not shown in the figure, the first reflective layer RL1 may contact the first electrode E1 and be electrically connected to the first electrode E1, thereby improving the bonding between the first electrode E1 and the bonding pad PD1. In some embodiments, the first reflective layer RL1 may have high reflectivity, but the first reflective layer RL1 is not conductive. In the present embodiment, the bonding pad PD1 may include any suitable conductive material, such as gold (Au), tin (Sn), indium (In), copper (Cu) or other suitable metal materials, but not limited thereto.

In the present embodiment, the first semiconductor die DI1 may be encapsulated by being embedded in the first filling layer FL1 at first, and then the encapsulated first semiconductor die DI1 is transferred to the opening OP1 of the insulating layer IN1, but not limited thereto. Specifically, the first semiconductor die DI1 may be provided at first, and then the first filling layer FL1 surrounding the first semiconductor die DI1, the first reflective layer RL1 surrounding the first filling layer FL1 and the first electrode E1 are disposed to form an encapsulated structure. After that, the insulating layer IN1 may be disposed on the substrate SB, the opening OP1 may be formed in the insulating layer IN1, and the encapsulated structure including the first semiconductor die DI1 may be disposed in the opening OP1 in the way that the first electrode E1 faces the bonding pad PD1, such that the first electrode E1 is electrically connected to the bonding pad PD1, thereby completing the disposition of the first semiconductor die DI1. In other embodiments, the first semiconductor die DI1, the first filling layer FL1, the first reflective layer RL1 and the first electrode E1 may be disposed in the opening OP1 in a suitable order.

According to the present embodiment, the semiconductor device SD may further include an underfill material UF disposed in the opening OP1. Specifically, after the above-mentioned encapsulated structure including the first semiconductor die DI1 is disposed in the opening OP1, the underfill material UF may be filled into the opening OP1 to fix the first semiconductor die DI1, or fix the encapsulated structure including the first semiconductor die DI1. In such condition, the underfill material UF may contact the first reflective layer RL1. The underfill material UF may include acrylic, siloxane, silicon dioxide, other suitable materials, or combinations of the above-mentioned materials. The underfill material UF may at least expose the surface of the first semiconductor die DI1 away from the substrate SB, that is, the surface SR6, such that the second semiconductor die electrically connected to the first semiconductor die DI1 can be disposed on the first semiconductor die DI1 in subsequent process. In the present embodiment, the top surfaces (or the surfaces away from the substrate SB) of the insulating layer IN1, the underfill layer UF, the first reflective layer RL1, the first filling layer FL1 and the first semiconductor die DI1 may be coplanar with each other, but not limited thereto. In other embodiments, as long as the surface SR6 of the first semiconductor die DI1 is not covered by the underfill material UF, the top surfaces of the insulating layer IN1, the underfill layer UF, the first reflective layer RL1, the first filling layer FL1 and the first semiconductor die DI1 may have any suitable height relationship.

According to the present embodiment, the second semiconductor die DI2 may be disposed on the first semiconductor die DI1 and be electrically connected to the first semiconductor die DI1. Therefore, the first semiconductor die DI1 and the second semiconductor die DI2 may form the die stacking structure DIS. Specifically, the semiconductor device SD further includes an insulating layer IN2 disposed on the insulating layer IN1, wherein the insulating layer IN2 may include an opening OP2, and the second semiconductor die DI2 is disposed in the opening OP2. The opening OP2 may correspond to the opening OP1, or the opening OP2 at least partially overlaps the opening OP1 in the normal direction (that is, the direction Z) of the semiconductor device SD, such that the second semiconductor die DI2 may be electrically connected to the first semiconductor die DI1. In detail, after the underfill material UF is disposed, the insulating layer IN2 may be disposed on the insulating layer IN1, and the opening OP2 corresponding to the opening OP1 may be formed in the insulating layer IN2, wherein the opening OP2 may expose the first semiconductor die DI1, or expose the surface SR6 of the first semiconductor die DI1. After that, the second semiconductor die DI2 may be disposed in the opening OP2 at a position corresponding to the first semiconductor die DI1 to electrically connect the second semiconductor die DI2 to the first semiconductor die DI1. Specifically, the semiconductor device SD further includes a bonding layer BL disposed between the first semiconductor die DI1 and the second semiconductor die DI2, wherein the bonding layer BL may be used to electrically connect the first semiconductor die DI1 and the second semiconductor die DI2. The electrical connection ways of the first semiconductor die DI1 and the second semiconductor die DI2 and the structural features of the bonding layer BL may refer to FIG. 2 and related contents above, which will not be redundantly described. It should be noted that in the process of disposing the second semiconductor die DI2, the second semiconductor die DI2 may be offset from the first semiconductor die DI1 due to process tolerances. In such condition, as shown in FIG. 5, the sidewall SW2 of the second semiconductor die DI2 may be offset from the sidewall SW1 of the first semiconductor die DI1. The range of the offset distance between the sidewall SW2 and the sidewall SW1 may refer to the range of the distance DS mentioned above, and will not be redundantly described.

According to the present embodiment, the second filling layer FL2 may be disposed in the opening OP2 and surround the sidewall (for example, the sidewall SW2) of the second semiconductor die DI2. Specifically, in a top view of the semiconductor device SD (not shown), the second filling layer FL2 may be disposed along the outer edge of the second semiconductor die DI2 and surround the second semiconductor die DI2. The second reflective layer RL2 may be disposed in the opening OP2 and located on the sidewall SW7 of the second filling layer FL2. Specifically, the second reflective layer RL2 may surround the second filling layer FL2 and cover the side surface of the second filling layer FL2. The second reflective layer RL2 is not connected to the first reflective layer RL1, or the first reflective layer RL1 and the second reflective layer RL2 are not continuous, but not limited thereto. In some embodiments, after the second semiconductor die DI2 is disposed, the second reflective layer RL2 may be formed on the sidewall of the opening OP2 at first, and then the second filling layer FL2 may be disposed between the second reflective layer RL2 and the second semiconductor die DI2. In some embodiments, after the second semiconductor die DI2 is disposed, the second filling layer FL2 surrounding the second semiconductor die DI2 may be disposed in the opening OP2 at first, and then the second reflective layer RL2 is disposed between the second filling layer FL2 and the sidewall of the opening OP2. The surface SR3 of the second semiconductor die DI2 away from the first semiconductor die DI1 may not be lower than the top surface (that is, the surface SR7) of the insulating layer IN2, such that the first conductive layer TL1 subsequently disposed on the insulating layer IN2 may contact the second semiconductor die DI2, thereby being electrically connected to the second semiconductor die DI2. For example, in the present embodiment, the top surfaces (or the surfaces away from the substrate SB) of the insulating layer IN2, the second reflective layer RL2, the second filling layer FL2 and the second semiconductor die DI2 may be coplanar with each other, but not limited thereto. The material selection or structural feature of the second semiconductor die DI2 may refer to the contents above, and will not be redundantly described. The material of the second filling layer FL2 may refer to the material of the filling layer FL mentioned above. The material of the second reflective layer RL2 may refer to the material of the reflective layer RL mentioned above. It should be noted that in some embodiments, the second reflective layer RL2 may have high reflectivity and high conductivity. In some embodiments, the second reflective layer RL2 may have high reflectivity, but the second reflective layer RL2 is not conductive.

According to the present embodiment, the first conductive layer TL1 may be disposed on the second semiconductor die DI2 and be electrically connected to the second semiconductor die DI2. Specifically, the first conductive layer TL1 may be disposed on the insulating layer IN2 and extend through the opening OP2, thereby contacting the second semiconductor die DI2 to be electrically connected to the second semiconductor die DI2. The material of the first conductive layer TL1 may refer to the material of the conductive layer TL mentioned above. According to the present embodiment, the first conductive layer TL1 may be electrically connected to the substrate SB, or electrically connected to the circuit layer of the substrate SB. Specifically, as shown in FIG. 5, the semiconductor device SD may include an opening OP3, wherein the opening OP3 may be formed by removing portions of the insulating layer IN1 and the insulating layer IN2. The opening OP3 may expose suitable conductive elements in the circuit layer of the substrate SB, such as the bonding pad PD2, and the first conductive layer TL1 may extend into the opening OP3 and contact the bonding pad PD2, thereby being electrically connected to the bonding pad PD2. In other words, the second semiconductor die DI2 may be electrically connected to the substrate SB through the first conductive layer TL1. The material of the bonding pad PD2 may refer to the material of the bonding pad PD1 mentioned above, and will not be redundantly described.

According to the present embodiment, the first conductive layer TL1 may serve as the electrode electrically connected to the second semiconductor die DI2, that is, the second electrode E2 mentioned above. That is, the first electrode E1 and the second electrode E2 may respectively be located at two opposite sides of the die stacking structure DIS. In addition, the bonding pad PD1 and the bonding pad PD2 may be the bonding pads electrically connected to the first electrode E1 and the second electrode E2 respectively. Through the structural design mentioned above, the light emission of the die stacking structure DIS (or the first semiconductor die DI1 and the second semiconductor die DI2) may be controlled through the substrate SB (for example, through the driving unit in the circuit layer of the substrate SB).

According to the present embodiment, the first semiconductor die DI1 located in an opening OP1 and the second semiconductor die DI2 located in an opening OP2 corresponding to the opening OP1 may be the semiconductor dies in a pixel (or a sub-pixel) of the semiconductor device SD. That is, a pixel (or a sub-pixel) of the semiconductor device SD may include a die stacking structure DIS formed by stacking two (or more) semiconductor dies, but not limited thereto. In such condition, the first semiconductor die DI1 and the second semiconductor die DI2 in the die stacking structure DIS may emit light of the same color, for example, the first semiconductor die DI1 and the second semiconductor die DI2 may both emit red light, green light or blue light, but not limited thereto. In some embodiments, the first semiconductor die DI1 and the second semiconductor die DI2 in the die stacking structure DIS may emit light of different colors. In addition, although it is not shown in FIG. 5, the semiconductor device SD may further include other openings OP1 and die stacking structures DIS disposed in these openings OP1, wherein the die stacking structures DIS may respectively emit light of a color. It should be noted that the colors of the light emitted from the die stacking structures DIS may be the same or different, it is not limited in the present disclosure. Therefore, the insulating layer IN1 and the insulating layer IN2 may serve as the pixel defining layer (PDL) in the present embodiment, but not limited thereto. In such condition, the insulating layer IN1 and the insulating layer IN2 may include organic photoresist, such as transparent photoresist, black photoresist or white photoresist, but not limited thereto.

According to the present embodiment, in a cross-sectional view of the semiconductor device SD, the opening OP2 may for example have a trapezoidal shape, wherein a width of the side of the opening OP2 closer to the substrate SB may be less than a width of the side of the opening OP2 farther from the substrate SB. In addition, the size of an opening OP2 may be greater than the size of the opening OP1 to which the opening OP2 correspond. "The size of the opening OP1 (or the opening OP2)" described herein may be the maximum width of the opening OP1 (or the opening OP2) in a cross-sectional view of the semiconductor device SD, but not limited thereto. For example, as shown in FIG. 5, in a cross-sectional view of the semiconductor device SD, the maximum width of the opening OP2 (for example, the width of the side of the opening OP2 away from the substrate SB) may be greater than the maximum width of the opening OP1. In other words, the maximum width of the second filling layer FL2 may be greater than the maximum width of the first filling layer FL1. In some embodiments, "the size of the opening OP1 (or the opening OP2)" may be the area of the opening OP1 (or the opening OP2) in a top view of the semiconductor device SD. For example, in a top view of the semiconductor device SD (not shown), the area of the opening OP1 may be less than the area of the opening OP2. Moreover, although it is not labeled in FIG. 5, in the present embodiment, the range of the included angle between the sidewall of the opening OP2 (or the sidewall of the second reflective layer RL2 or the sidewall SW7 of the second filling layer FL2) and the surface of the insulating layer IN1 away from the substrate SB and the range of the included angle between the sidewall SW5 of the first filling layer FL1 and the surface SR2 of the first filling layer FL1 may refer to the range of the included angle θ1 mentioned above, but not limited thereto. Through the size design or structural design mentioned above, the light emitting effect of the semiconductor device SD may be improved.

It should be noted that the semiconductor device SD of the present embodiment may further include other suitable elements or layers, which is not limited to the structure shown in FIG. 5.

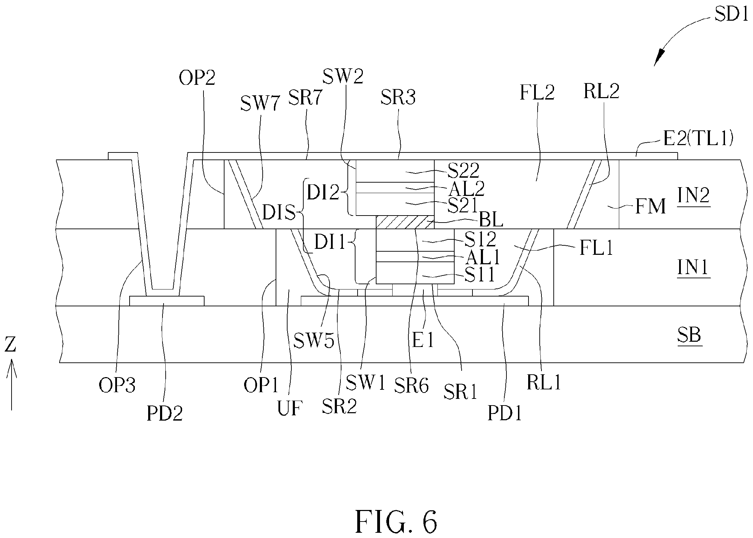

Referring to FIG. 6, FIG. 6 schematically illustrates a cross-sectional view of a semiconductor device according to a fourth embodiment of the present disclosure. One of the main differences between the semiconductor device SD1 of the present embodiment and the semiconductor device SD shown in FIG. 5 is the disposition way of the second semiconductor die DI2. Specifically, in the present embodiment, the second semiconductor die DI2 may be encapsulated by being embedded in the second filling layer FL2 at first, and then the encapsulated second semiconductor die DI2 is transferred to the opening OP2 of the insulating layer IN2, but not limited thereto. Specifically, after the first semiconductor die DI1 and the underfill material UF are disposed, the second semiconductor die DI2 may be provided at first, and then the second filling layer FL2 surrounding the second semiconductor die DI2 and the second reflective layer RL2 surrounding the second filling layer FL2 may be disposed to form an encapsulated structure. After that, the insulating layer IN2 may be disposed on the insulating layer IN1, the opening OP2 may be formed in the insulating layer IN2, and the encapsulated structure including the second semiconductor die DI2 may be disposed in the opening OP2, such that the second semiconductor die DI2 may be electrically connected to the first semiconductor die DI1 (for example, through the bonding layer BL). In addition, in the present embodiment, the semiconductor device SD1 may further include a filling material FM disposed in the opening OP2. Specifically, after the encapsulated structure including the second semiconductor die DI2 is disposed in the opening OP2, the filling material FM may be filled into the opening OP2 to fix the encapsulated structure of the second semiconductor die DI2. The material of the filling material FM may refer to the material of the underfill material UF mentioned above, but not limited thereto. The structural features of other elements or layers of the semiconductor device SD 1 may refer to the structure of the semiconductor device SD mentioned above, and will not be redundantly described.

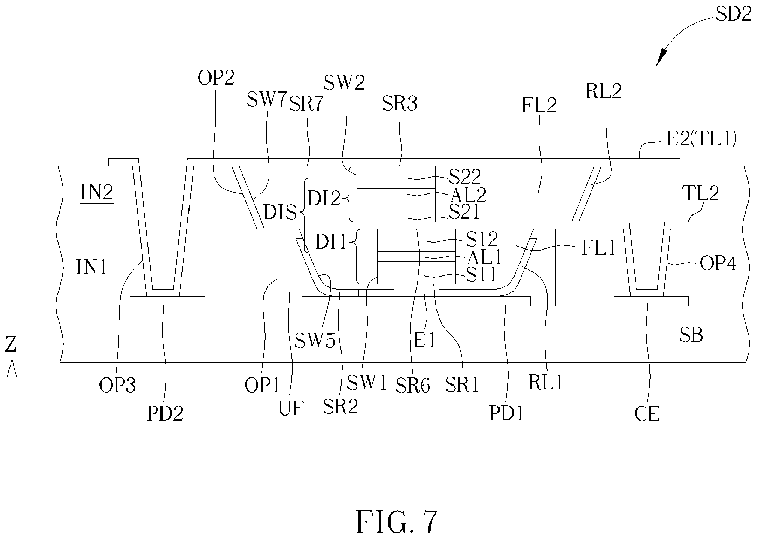

Referring to FIG. 7, FIG. 7 schematically illustrates a cross-sectional view of a semiconductor device according to a fifth embodiment of the present disclosure. According to the present embodiment, the semiconductor device SD2 may further include a second conductive layer TL2 disposed between the first semiconductor die DI1 and the second semiconductor die DI2. Specifically, after the underfill material UF and the first semiconductor die DI1 are disposed in the opening OP1, the second conductive layer TL2 may be disposed on the first semiconductor die DI1, and then the insulating layer IN2 is disposed. The second conductive layer TL2 may contact the first semiconductor die DI1 and the second semiconductor die DI2, and the second conductive layer TL2 may be electrically connected to the first semiconductor die DI1 and the second semiconductor die DI2. Therefore, the semiconductor device SD2 may not include the bonding layer BL mentioned above, and the second conductive layer TL2 may be used to electrically connect the first semiconductor die DI1 and the second semiconductor die DI2. Although it is not shown in FIG. 7, in some embodiments, the semiconductor device SD2 may include the bonding layer BL disposed between the second semiconductor die DI2 and the second conductive layer TL2. The material of the second conductive layer TL2 may refer to the material of the conductive layer TL mentioned above, but not limited thereto.

According to the present embodiment, the second conductive layer TL2 may be electrically connected to the substrate SB, or the second conductive layer TL2 may be electrically connected to the conductive element (that is, the conductive element CE shown in FIG. 7) in the circuit layer of the substrate SB. Specifically, as shown in FIG. 7, the semiconductor device SD2 may further include at least one opening OP4, wherein the opening OP4 may for example be formed by removing a portion of the insulating layer IN1. The opening OP4 may expose the conductive element CE of the substrate SB, and the second conductive layer TL2 may extend on the insulating layer IN1 and enter the opening OP4 to contact the conductive element CE, thereby being electrically connected to the conductive element CE. In the present embodiment, the conductive element CE may include any suitable electronic element, or the conductive element CE may be electrically connected to any suitable electronic element, based on the design of the semiconductor device SD2. For example, in the present embodiment, the conductive element CE may include a switch element, or the conductive element CE may be electrically connected to a switch element, but not limited thereto. It should be noted that the second reflective layer RL2 is not electrically connected between the second conductive layer TL2 and the first conductive layer TL1. For example, in some embodiments, as shown in FIG. 7, the second reflective layer RL2 may contact the second conductive layer TL2 and the first conductive layer TL1, and the second reflective layer RL2 may not include conductive material. In some embodiments, the second reflective layer RL2 may not contact at least one of the second conductive layer TL2 and the first conductive layer TL1. In addition, in the present embodiment, the first reflective layer RL1 may not contact the second conductive layer TL2.

According to the present embodiment, through the disposition of the second conductive layer TL2, the semiconductor device SD2 may have various display modes. Specifically, in some embodiments, the second conductive layer TL2 may be grounded, for example, the second conductive layer TL2 may be grounded through the conductive element CE. At this time, the driving electrical signal of the semiconductor die may pass through the first electrode E1, the first semiconductor die DI1 and the second conductive layer TL2. In such condition, the semiconductor device SD2 may have a first display mode, wherein in the first display mode, the first semiconductor die DI1 may emit light, and the second semiconductor die DI2 may not emit light. In the first display mode, since only the first semiconductor die DI1 in the die stacking structure DIS emits light, the first display mode may be a narrow viewing angle display mode. For example, in the first display mode, the light emitted by the semiconductor device SD2 may be more concentrated, or the brightness of the light emitted by the semiconductor device SD2 at a small viewing angle may increase. In some embodiments, the second conductive layer TL2 may be floating. At this time, the driving electrical signal of the semiconductor die may pass through the first electrode E1, the first semiconductor die DI1, the second conductive layer TL2, the second semiconductor die DI2 and the first conductive layer TL1. In such condition, the semiconductor device SD2 may have a second display mode, wherein in the second display mode, the first semiconductor die DI1 and the second semiconductor die DI2 may both emit light. In the second display mode, since the first semiconductor die DI1 and the second semiconductor die DI2 in the die stacking structure DIS both emit light, the second display mode may be a high brightness display mode. Specifically, the brightness of the semiconductor device SD2 in the second display mode (that is, the brightness of the light emitted by the semiconductor device SD2 in the second display mode) may be greater than the brightness of the semiconductor device SD2 in the first display mode. In some embodiments, the second conductive layer TL2 may provide current to the second semiconductor die DI2, for example, a current may be provided by the conductive element CE and pass through the second conductive layer TL2, the second semiconductor die DI2 and the first conductive layer TL1. In such condition, the semiconductor device SD2 may have a third display mode, wherein in the third display mode, the second semiconductor die DI2 may emit light, and the first semiconductor die DI1 may not emit light. In the third display mode, since only the second semiconductor die DI2 in the die stacking structure DIS emits light, the third display mode may be a wide viewing angle display mode. For example, the brightness of a large-angle light emitted by the semiconductor device SD2 in the third display mode may be greater than the brightness of a large-angle light emitted by the semiconductor device SD2 in the first display mode. In other words, through the circuit design of the second conductive layer TL2, the first semiconductor die DI1 and the second semiconductor die DI2 in the die stacking structure DIS may emit light independently, thereby making the semiconductor device SD2 have various display modes.

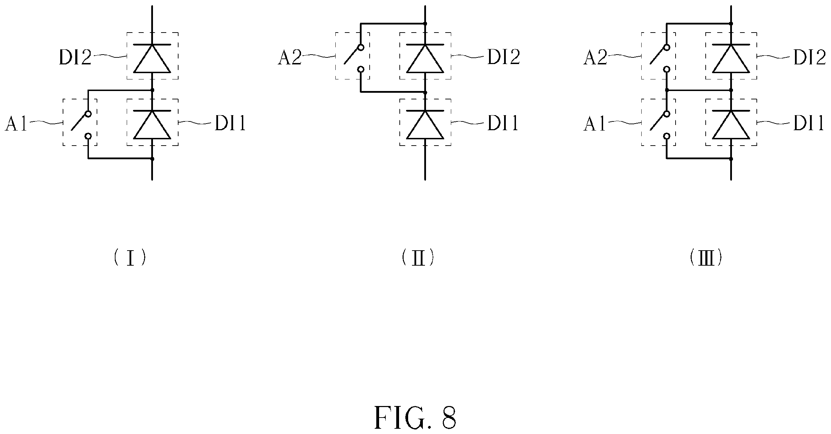

Referring to FIG. 8, FIG. 8 schematically illustrates the circuit diagrams of the semiconductor device in different operating modes according to the fifth embodiment of the present disclosure. Specifically, FIG. 8 shows several examples of controlling the display mode of the semiconductor device SD2 through at least one switching element. In detail, in some embodiments, as shown in the circuit (I) of FIG. 8, the conductive element CE mentioned above may be a switch element A1, wherein two ends of the switch element A1 are electrically connected to the p electrode and the n electrode of the first semiconductor die DI1 respectively, or the conductive element CE may be electrically connected to the switch element A1. In such condition, when the switch element A1 is turned off (or an open circuit is formed), the first semiconductor die DI1 and the second semiconductor die DI2 may both emit light, and the semiconductor device SD2 may have the second display mode mentioned above; and when the switch element A1 is turned on (or a short circuit is formed), the second semiconductor die DI2 may emit light, and the first semiconductor die DI1 may not emit light, and the semiconductor device SD2 may have the third display mode mentioned above. In some embodiments, as shown in the circuit (II) of FIG. 8, the conductive element CE mentioned above may be a switch element A2, wherein two ends of the switch element A2 are electrically connected to the p electrode and the n electrode of the second semiconductor die DI2 respectively, or the conductive element CE may be electrically connected to the switch element A2. In such condition, when the switch element A2 is turned off (or an open circuit is formed), the first semiconductor die DI1 and the second semiconductor die DI2 may both emit light, and the semiconductor device SD2 may have the second display mode mentioned above; and when the switch element A2 is turned on (or a short circuit is formed), the first semiconductor die DI1 may emit light, and the second semiconductor die DI2 may not emit light, and the semiconductor device SD2 may have the first display mode mentioned above. In some embodiments, as shown in the circuit (III) of FIG. 8, the semiconductor device SD2 may include the switch element A1 and the switch element A2, wherein two ends of the switch element A1 are electrically connected to the p electrode and the n electrode of the first semiconductor die DI1 respectively, and two ends of the switch element A2 are electrically connected to the p electrode and the n electrode of the second semiconductor die DI2 respectively. Or, the conductive element CE may include the switch element A1 and the switch element A2 shown in the circuit (III) of FIG. 8. In such condition, the switch element A1 and the switch element A2 may respectively be turned on or turned off, thereby independently controlling the light emission of the first semiconductor die DI1 and the second semiconductor die DI2 and making the semiconductor device SD2 have the first display mode, the second display mode or the third display mode mentioned above. It should be noted that the semiconductor device SD2 of the present embodiment may present different display mode through other suitable ways, which is not limited to the methods mentioned above.

In summary, a semiconductor chip or a semiconductor device is provided by the present disclosure, wherein a pixel (or a sub-pixel) of the semiconductor chip or the semiconductor device may include a die stacking structure formed by stacking a plurality of semiconductor dies which are connected to each other in series. Therefore, driving efficiency or energy utilization efficiency of the semiconductor chip or the semiconductor device may be improved.

Those skilled in the art will readily observe that numerous modifications and alterations of the device and method may be made while retaining the teachings of the disclosure. Accordingly, the above disclosure should be construed as limited only by the metes and bounds of the appended claims.

## Claims

1. A semiconductor chip (SC), **characterized by** comprising:
a first semiconductor die (DI1);
a second semiconductor die (DI2) disposed on the first semiconductor die (DI1) and electrically connected to the first semiconductor die (DI1);
a filling layer (FL) surrounding a sidewall (SW1,SW3) of the first semiconductor die (DI1) and a sidewall (SW2, SW4) of the second semiconductor die (DI2);
a conductive layer (TL) disposed on the second semiconductor die (DI2) and the filling layer (FL) and electrically connected to the second semiconductor die (DI2); and
a reflective layer (RL) disposed on a sidewall (SW5) of the filling layer (FL).

2. The semiconductor chip (SC) of claim 1, **characterized by** further comprising a bonding layer (BL) disposed between the first semiconductor die (DI1) and the second semiconductor die (DI2), wherein the bonding layer (BL) is used for electrically connecting the first semiconductor die (DI1) and the second semiconductor die (DI2).

3. The semiconductor chip (SC) of claim 1 or claim 2, **characterized by** further comprising a first electrode (E1) and a second electrode (E2), wherein the first electrode (E1) is disposed below the first semiconductor die (DI1) and electrically connected to the first semiconductor die (DI1), and the second electrode (E2) is disposed below the filling layer (FL) and electrically connected to the conductive layer (TL) through the reflective layer (RL).

4. The semiconductor chip (SC1) of any one of claim 1 to claim 3, **characterized in that** the reflective layer (RL) includes a first sub layer (SL1) and a second sub layer (SL2) disposed on the first sub layer (SL1), and a reflectivity of the first sub layer (SL1) to visible light is greater than a reflectivity of the second sub layer (SL2) to visible light.

5. The semiconductor chip (SC1) of any one of claim 1 to claim 4, **characterized in that** the reflective layer (RL) includes a first sub layer (SL1) and a second sub layer (SL2) disposed on the first sub layer (SL1), and a conductivity of the second sub layer (SL2) is greater than a conductivity of the first sub layer (SL1).

6. The semiconductor chip (SC1) of any one of claim 1 to claim 5, **characterized in that** in a cross-sectional view of the semiconductor chip (SC1), a maximum width (W2) of the second semiconductor die (DI2) is less than a maximum width (W1) of the first semiconductor die (DI1).

7. The semiconductor chip (SC1) of any one of claim 1 to claim 6, **characterized in that** in a cross-sectional view of the semiconductor chip (SC1), the sidewall (SW1,SW3) of the first semiconductor die (DI1) is not aligned with the sidewall (SW2,SW4) of the second semiconductor die (DI2).

8. A semiconductor device (SD), **characterized by** comprising:
a substrate (SB);
a first semiconductor die (DI1) disposed on the substrate (SB);
a second semiconductor die (DI2) disposed on the first semiconductor die (DI1) and electrically connected to the first semiconductor die (DI1);
a first filling layer (FL1) surrounding a sidewall (SW1) of the first semiconductor die (DI1);
a second filling layer (FL2) surrounding a sidewall (SW2) of the second semiconductor die (DI2);
a first conductive layer (TL1) disposed on the second semiconductor die (DI2) and electrically connected to the second semiconductor die (DI2);
a first reflective layer (RL1) disposed on a sidewall (SW5) of the first filling layer (FL1); and
a second reflective layer (RL2) disposed on a sidewall (SW7) of the second filling layer (FL2).

9. The semiconductor device (SD) of claim 8, **characterized in that** in a cross-sectional view of the semiconductor device (SD), a maximum width of the second filling layer (FL2) is greater than a maximum width of the first filling layer (FL1).

10. The semiconductor device (SD2) of claim 8 or claim 9, **characterized by** further comprising a second conductive layer (TL2) disposed between the first semiconductor die (DI1) and the second semiconductor die (DI2) and electrically connecting the first semiconductor die (DI1) and the second semiconductor die (DI2).

11. The semiconductor device (SD2) of claim 10, **characterized in that** the semiconductor device (SD2) has a first display mode and a second display mode, the second conductive layer (TL2) is grounded in the first display mode, and the second conductive layer (TL2) is floating in the second display mode.

12. The semiconductor device (SD2) of claim 11, **characterized in that** the first display mode is a narrow viewing angle display mode, and the second display mode is a high brightness display mode.

13. The semiconductor device (SD2) of claim 11 or claim 12, **characterized in that** a brightness of the semiconductor device (SD2) in the second display mode is greater than the brightness of the semiconductor device (SD2) in the first display mode.

14. The semiconductor device (SD2) of any one of claim 10 to claim 13, **characterized in that** the semiconductor device (SD2) has a third display mode, and the second conductive layer (TL2) provides a current to the second semiconductor die (DI2) in the third display mode.

15. The semiconductor device (SD2) of claim 14, **characterized in that** the third display mode is a wide viewing angle display mode.
